# EUROPÄISCHE PATENTSCHRIFT

(11) **EP 2 556 412 B1**
(45) Veröffentlichungstag und Bekanntmachung des Hinweises auf die Patenterteilung: **02.12.2015**
(21) Anmeldenummer: 11714733.0
(22) Anmeldetag: 07.04.2011
(51) Int. Cl.: G03H 1/20

(54) **VERFAHREN UND VORRICHTUNG ZUM HERSTELLEN VON KONTAKTKOPIEN VON REFLEXIONS-VOLUMENHOLOGRAMMEN**
METHOD AND DEVICE FOR PRODUCING CONTACT PRINTS OF VOLUME REFLECTION HOLOGRAMS
PROCÉDÉ ET DISPOSITIF POUR PRODUIRE DES COPIES PAR CONTACT D'HOLOGRAMMES VOLUMIQUES PAR RÉFLEXION

(30) Priorität: 09.04.2010 DE 102010014305
(43) Veröffentlichungstag der Anmeldung: 13.02.2013
(73) Patentinhaber: Hologram Industries Research GmbH, 85652 Pliening-Ottersberg (DE)
(72) Erfinder: DAUSMANN, Günther, 85630 Grassbrunn (DE)
(74) Vertreter: Farago, Peter Andreas
(86) Internationale Anmeldenummer: PCT/EP2011/055420
(87) Internationale Veröffentlichungsnummer: WO 2011/124641

(56) Entgegenhaltungen:
- WO-A1-80/02400
- DE-A1-102007 042 385
- GB-A- 1 117 973
- JP-A- 5 249 876
- JP-A- 5 249 877
- JP-A- 2000 019 936
- US-A- 4 973 113
- US-A- 5 003 386
- US-A- 6 055 075
- US-A1- 2008 279 587

## Beschreibung

Die Erfindung betrifft ein Verfahren und eine Vorrichtung zum Herstellen von Kontaktkopien von Reflektions-Volumenhologrammen gemäß dem Oberbegriff des Anspruchs 1 bzw. des Anspruchs 7.

Aus der DE 198 09 502 A1 ist bekannt, Kontaktkopien von einem Reflexionsvolumenhologramm dadurch herzustellen, dass ein Master-Hologramm auf einem Flachbett befestigt und auf dem Master ein holographischer Film aufgedrückt und anschließend belichtet wird. Um lokale Spannungen in dem Film zu vermeiden, muss nach dem Andrücken des Films auf das Master-Hologramm eine bestimmte Wartezeit eingehalten werden. Um eine schnelle Serienproduktion von hohen Stückzahlen zu erreichen, sind Pufferzonen vorzusehen, in welchen der Film die erforderliche Wartezeit von etwa 4 bis 5 Sekunden verbleibt, bevor das Hologramm als Ganzes belichtet wird, um das Master-Hologramm in der Photopolymerschicht des Films zu reproduzieren.

Ähnlich wird auch zur Herstellung von Reflexions-Hologrammen vorgegangen, die insbesondere in Sicherheitselementen in großen Mengen benötigt werden. Zur Herstellung eines Reflexions-Hologramms wird ein transparentes Master-Hologramm auf einen reflektierenden Photopolymerfilm bzw. einen Photopolymerfilm mit einer reflektierenden Trägerschicht aufgelegt, um eine Kontaktkopie des Master-Hologramms herzustellen.

So u. a. ist aus der vorerwähnten DE 198 09 502 A1 sowie den EP 0 726 142 B1, JP 05249877 A und JP 03148687 A zum Kopieren/Duplizieren von Reflexionshologrammen bekannt, auf einer rotierenden Trommel mindestens ein Reflexions-Masterhologramm zu befestigen. Dabei wird ein photosensitiver Film kontinuierlich über die auf der Trommel fixierten Masterhologramme gelegt und wird mit diesem sich mitbewegend geführt und Laser-belichtet. Zur Belichtung wird ein quer linienförmig aufgeweiteter konvergenter Laserstrahl verwendet, der linear in entsprechendem Rekonstruktionswinkel von z. B. 45° (wegen der Bragg'schen Ebenen) auf die zu belichtende gekrümmte Fläche auftrifft. Daher ist eine bestimmte, relativ hohe Belichtungszeit für die Polymerbelichtung notwendig, bis der Master, mit darauf befindlichem Film in ganzer Umfangslänge belichtet ist. Für großflächige Hologramme wird somit relativ viel Zeit dafür benötigt, was selbstverständlich auch kostenmäßig hoch zu Buche schlägt. Zwar könnte durch schnelleres Rotieren der Trommel eine Erhöhung der Produktivität erreicht werden, jedoch führt dies zu einer Verschlechterung der Qualität der erhaltenen Kopien/Repliken.

Schließlich ist aus der JP 05-249876 A ein Verfahren zur Herstellung von Hologrammkopien bekannt, bei dem ein Film über eine rotierende polygonale Trommel, vorzugsweise eine quadratische Trommel geführt wird, auf deren ebenen Polygon-Flächen je ein Masterhologramm befestigt ist. Die Trommel wird dabei intermittierend schrittweise so rotiert, dass sich jeweils eine Master-Fläche mit darauf befindlichem Master-Hologramm bei Stillstand komplett im flächigen Belichtungsbereich eines divergenten Laserstrahls befindet. Durch die Divergenz des in vorbestimmten Winkel vollflächig auftreffenden Belichtungsstrahls ist insbesondere bei Belichtung von großflächigen Master-Hologrammen der Einfall- und somit Rekonstruktionswinkel nicht über die gesamte Länge und/oder Breite des Masters identisch, so dass auch die Kopie bzw. Rekonstruktion nicht über die gesamte Fläche identisch ist und damit die Qualität der Kopie erheblich leidet.

Dokument DE 10 2007 042 385 offenbart die Mitbewegung der Laserstrahlung über einen Spiegel mit der Rotation einer zylindrischen Trommel bei der Herstellung von Refexionshologrammen.

Der Erfindung liegt somit die **Aufgabe** zugrunde, ein Verfahren und eine Vorrichtung oben genannter Gattung bereitzustellen, das/die eine Erhöhung der Produktivität bei der Herstellung auch großflächiger Hologramme, unter Beibehaltung einer hohen gleichmäßigen Kopier-Qualität, ermöglicht.

Diese Aufgabe wird durch ein Verfahren mit den Merkmalen des Anspruchs 1 und durch eine Vorrichtung mit den Merkmalen des Anspruchs 7 gelöst. Vorteilhafte Ausgestaltungen und Weiterbildungen der Erfindung ergeben sich aus den jeweilig rückbezogenen Unteransprüchen.

Dem gemäß wird die Trommel gleichmäßig rotiert, wobei sich jeweils mindestens eine Polygon-Fläche (Master-Fläche) mit darauf befindlichem Master in seiner ganzen Fläche im Belichtungsbereich befindet. Dabei ist die jeweilige Laser-Belichtung eine kohärente parallele Strahlung, die jeweils vollflächig über die gesamte Master-Fläche oder die Fläche der jeweiligen Master einer Master-Fläche oder mehrerer Master-Flächen gleichzeitig, erfolgt.

Durch das nunmehr vorgesehene Belichten des Hologramms in der kontinuierlich rotierenden Bewegung der Trommel bzw. des Films durch einen dabei abschnittsweise mit rotierenden ganzflächig belichtenden Laserstrahl, wird ein kontinuierlicher Prozess ermöglicht, durch welchen auch relativ sehr lange Bahnen von Filmen und/oder relativ große Master-Hologramme in einer einfachen wirtschaftlichen Weise gleichmäßig belichtet und somit reproduziert werden können.

Von besonderem Vorteil ist, dass jeweils eine Master-Fläche oder auch zwei oder mehr Master-Flächen gleichzeitig flächig laserbelichtet werden können, z. B. bei einem Achteck-Polygon mit acht Mastern, gleichzeitig vier oder mehr Master. Entsprechend hoch ist damit die Produktivität des erfindungsgemäßen Vorgehens. Werden dann auch noch mehrere Hologramme auf eine ebene Master-Fläche aufgespannt, dann wird die Produktivität nochmals entsprechend erhöht. Entsprechend sind dann auch die Preise für solche Repliken "erschwinglich".

Um zu vermeiden, dass an den jeweiligen Polygonecken, zwischen den aktiven Master-Flächen, der eine bestimmte Elastizität besitzende Film sich bauchig aufwerfend abhebt, ist von Vorteil, wenn eine Anpresseinrichtung z. B. eine von außen wirksame mechanische, pneumatische, hydraulische, elektrische, magnetische oder eine Kombination dieser Möglichkeiten betätigte Anpressrolle bzw. -walze und/oder ein von innen wirksames Vakuum (Unterdruck) eingesetzt wird. Dadurch wird ein enges Anliegen des Films auch über die Ecken/Kanten des Trommel-Polygons erreicht und somit insgesamt ein genaues Führen des Films über bzw. mit den Master-Flächen.

In einer weiteren Variante kann die Anpreßwalze an Ihrer z. B. federbelasteten Halterung exzentrisch so gelagert sein, dass sie die durch die Polygonecken der Trommel verursachten radialen Hübe ausgleicht. Dadurch wird ein konstanter Anpressdruck der Rolle erhalten, da nunmehr die Feder in Ihrer Länge nicht mehr den Rollenhub ausgleichen muss.

Zudem ist vorgesehen, dass bei einer jeden Trommelumdrehung die exzentrische Andrückwalze angehoben wird, z. B. über stirnseitig mit der Trommel mitlaufende Hebel mit endseitiger Anhebrolle, die mit beidseitig abragenden Excenterbolzen der Anpresswalze zusammenwirken. so dass die Umlauftoleranz ausgeglichen wird.

Um ein gleichmäßiges Komplett-Belichten der Masterflächen und somit der darauf befindlichen Hologramme auch bei kontinuierlich rotierender Polygon-Trommel zu erreichen, wird erfindungsgemäß vorgeschlagen, die Laser-Belichtungsquelle bzw. den Laserstrahl entsprechend der Trommelbewegung abschnittsweise zu verschieben und oder zu verschwenken bzw. mit zu verschwenken. Dies wird insbesondere durch entsprechendes Bewegen/Verschwenken der gesamten Belichtungseinrichtung oder ihrer den Kopier-Laserstrahl leitenden Spiegel erreicht, z. B. zumindest des letzten Spiegels, eventuell eines Hohlspiegels.

Bei Anordnung mehrerer Masterhologramme auf einer ebenen Masterfläche ist von Vorteil, wenn die (Innen-) Umfangsabstände zwischen den Mastern einer Fläche und die (Außen-) Abstände zwischen den Mastern direkt benachbarter Master-Flächen über die Polygonecken identisch sind. Hierdurch werden auf dem Film gleichmäßig zueinander beabstandete Hologramme erzeugt, so dass das Belichten und damit Kopieren selbst und danach das weitere Verarbeiten nach dem Entlaminieren des Films von der Trommel sehr genau erfolgen kann, mit nur minimalen Verlusten.

Um eine Vollbelichtung mit kohärenten Strahlen der Master-Flächen zu erhalten, kann erfindungsgemäß der Laserstrahl über einen ersten Spiegel als divergente Strahlung auf einen entsprechend geformten Hohlspiegel und von diesem als parallele Strahlung auf die Masterfläche im notwendigen Winkel gelenkt werden. Es können aber auch zwei Umlenkspiegel eine parallele Strahlung entsprechend weiterleiten

Die zur Durchführung des vorbeschriebenen Verfahrens dienende erfindungsgemäße Vorrichtung umfasst insbesondere eine polygonale Trommel mit mindestens zwei ebenen (Polygon-) Master-Flächen zum Mitführen des Films und zum Kontaktieren des Films mit dem jeweils in Umfangsrichtung gesehen mindestens einen auf der jeweiligen Masterfläche befestigten Master-Hologramm, wobei wesentlich ist, dass jeweils einer Master-Fläche mindestens eine kohärente Laserlichtquelle zu deren ganzflächigen Belichtung zugeordnet ist. Zudem ist ein Antriebsmechanismus zum konstanten simultanen Bewegen der Trommel und damit der darauf befindlichen mehreren Master-Hologramme und des holographischen Films vorgesehen. Selbstverständlich ist zudem mindestens eine erste und eine zweite Kontaktierungsrolle (Führungs- und/oder Spannrolle) zum Kontaktieren des Master-Hologramms mit dem Film (Auflaminieren und Entlaminieren) angeordnet, so dass insgesamt ein optimales Auflaminieren, Transportieren, Laser-Belichten und Entlaminieren des Films und somit Kopieren auch von großflächigen Hologrammen möglich ist.

Schließlich ist die mindestens eine Belichtungseinheit so ausgelegt, dass sie jeweils abschnittsweise der konstanten Rotationsbewegung der Trommel mit gleicher Geschwindigkeit so weit folgt, wie die notwendige Belichtungszeit für die zugehörige Master-Fläche dies erforderlich macht. Danach wird die Belichtungseinheit schnell wieder in ihre Anfangsposition zurückgesetzt, um dann gemeinsam mit der nächsten Master-Fläche die gleiche Winkel-Verschwenkung in Rotationsrichtung der Trommel und die notwendige ganzflächige Belichtung durchzuführen.

Es ist ersichtlich, dass diese Vorrichtung in äußerst platzsparender einfacher Weise aufgebaut und wirksam ist und überraschende Ergebnisse erzielt. Durch diese Vorrichtung ist es nämlich nunmehr möglich, sehr wirtschaftlich, also in hoher Geschwindigkeit und somit hoher Anzahl Repliken von großflächigen Hologrammen schnell in zudem sehr hoher Qualität herzustellen.

Wie bereits ausgeführt, kann die erfindungsgemäße Polygon-Trommel im Querschnitt unterschiedlich ausgelegt sein, nämlich mit mindestens zwei ebenen Master-Flächen. So kann im Querschnitt gesehen die Trommel u. a. ein flaches Rechteck mit zwei zueinander parallelen Master-Flächen, ein gleichseitiges Dreieck mit drei Master-Flächen, ein Quadrat mit vier Master-Flächen oder ein Fünfeck, Sechseck, Siebeneck, Achteck oder ganz allgemein ein n-Eck mit entsprechender Anzahl von Master-Flächen sein. Dabei ist der Film über mindestens eine, vorzugsweise zwei bis n-1 Master-Flächen kopiewirksam geführt, aktive Master-Flächen darstellend, wobei gleichzeitig eine oder mehrere Belichtungseinheiten den aktiven Masterflächen zugeordnet sein können.

So können z. B bei einer Achteck-Trommel vier aktive Master-Flächen vorhanden sein, also der Film über vier der acht Master-Flächen so geführt bzw. mitgeführt sein, dass bedarfsweise mindestens eine dieser Flächen optimal Laser-belichtbar ist, ja sogar eine gleichzeitige Belichtung von zwei oder gar aller vier Flächen möglich ist. Es besteht aber hierbei die Möglichkeit, alle vier aktiven Masterflächen gleichzeitig zu belichten. Letztere Variante hat den Vorteil, dass die dann für die vier Belichtungseinrichtungen ausreichend Zeit zum ordnungsgemäßen Rückstellen verbleibt.

Vorteilhaft wirkt sich aus, wenn die vorgesehene Anpresseinrichtung, z. B. mit einer von außen wirksamen mechanisch, pneumatische, hydraulisch, elektrisch, magnetisch (oder eine entsprechende Kombination) betätigten Anpressrolle/-walze und/oder einem von innen wirksamen Vakuum (Unterdruck) ausgestattet ist. Hierdurch wird sicher gestellt, dass der zwar elastische, aber doch eine gewisse Feder-Steifheit besitzende Film auch an den Polygon-Ecken, über die er geführt bzw. gelegt wird, sich ausreichend eng anlegt und nicht in größerem Radius als derjenige des Eckes biegt und damit "baucht". Dies kann insbesondere bei einer Polygon-Trommel mit geringer Flächenanzahl der Fall sein, so z. B. bei Vorhandensein von nur drei Flächen, also Dreieck-Querschnitt, da dann spitze Eckwinkel von nur 60° vorhanden sind. Je höher die Flächen-Anzahl, desto größer sind die Eckwinkel und somit einfacher/leichter die erreichbare satt anliegende Umschlingung durch den Film. So sind bei einem Achteck Eckwinkel von 145° vorhanden, wodurch die Umschlingung optimal möglich ist, auch ohne zusätzliche Anpresseinrichtung.

Ein besonders vorteilhafter, konstanter Anpressdruck wird erreicht, wenn die federbelastete Anpresswalze exzentrisch gelagert ist, so dass der durch die Polygonecken während der Trommelrotation veranlasste Radialhub durch die Anpreßwalze ausgeglichen wird und nicht allein durch die Federlänge. Dabei kann gleichzeitig ein Ausgleich der Umlauftoleranz erreicht werden, wenn die Anpresswalze bei einer jeden Umdrehung der Trommel mit Hilfe von jeweils stirnseitig vorgesehenen Hebeln und deren endseitiger Abhebrolle, zumindest leicht angehoben wird.

Des Weiteren ist möglich, dass die Belichtungseinheit mindestens einen verstellbaren Umlenkspiegel besitzt, der bei kontinuierlich rotierender Trommel eine entsprechende Schwenkbewegung mit identischer Winkelgeschwindigkeit ausführt, wie bereits vorbeschrieben.

Die Belichtungseinrichtung kann zudem mindestens einen letzten Spiegel umfassen, der parallele Strahlen zur Masterbelichtung abgibt, wobei bei Vorhandensein von zwei Spiegeln, der erste Spiegel eine divergierende Strahlung abgibt und der zweite, ein Hohlspiegel, diese Strahlung in parallele kohärente vollbelichtende Strahlung umwandelt.

Schließlich besteht die Möglichkeit, die Master-Trommel als magnetische oder mit magnetischen Elementen ausgerüstete Trommel auszubilden. Damit können z. B. die Anpresseinrichtung wie Anpressrollen, und/oder die Auf- und die Entlaminierungsrollen bzw. -walzen ebenfalls magnetwirksam ausgerüstet sein, so dass diese keine zusätzliche Anpressvorkehrungen benötigen.

Nachfolgend wird die Erfindung anhand mehrerer Ausführungsbeispiele unter Bezug auf die Zeichnung näher erläutert. Es zeigen:
- Fig. 1:: schematisch eine Vorrichtung in erster Ausführung mit Quadrat-Trommel,
- Fig. 2:: die Vorrichtung nach Fig. 1 in verschwenkter Position der Trommel,
- Fig. 3:: eine Perspektiv-Ansicht einer Quadrat-Trommel in Ausführung mit je einem Masterhologramm pro Master-Fläche,
- Fig. 4:: eine Perspektiv-Ansicht einer Quadrat-Trommel in Ausführung mit je zwei Masterhologrammen pro Master-Fläche,
- Fig. 5:: eine Stirn-Schnittansicht der Trommel nach Fig. 4,
- Fig. 6:: schematisch die Anordnung einer Anspressrolle/-walze an einem Polygon-Eck,
- Fig. 7:: den Film an einem Polygon-Eck mit Anpresseinrichtungen,
- Fig. 8:: schematisch eine Trommel mit Belichtungseinrichtung in erster Ausführung,
- Fig. 9:: schematisch eine Trommel mit Belichtungseinrichtung in zweite Ausführung,
- Fig. 10:: schematisch eine Vorrichtung mit Dreieck-Trommel,
- Fig. 11:: schematisch eine Vorrichtung mit flacher Rechteck-Trommel,
- Fig. 12:: schematisch eine Vorrichtung mit Achteck-Trommel,
- Fig. 13:: eine Perspektiv-Ansicht der Trommel der Vorrichtung nach Fig. 12,
- Fig. 14:: eine Frontansicht mit Anpresseinrichtung ähnlich der aus Fig. 6 + 7,
- Fig. 15:: die Vorrichtung nach Fig. 14 in um 45° gedrehte Position, und
- Fig. 16:: eine Perspektivansicht der Vorrichtung aus Fig. 14 + 15.

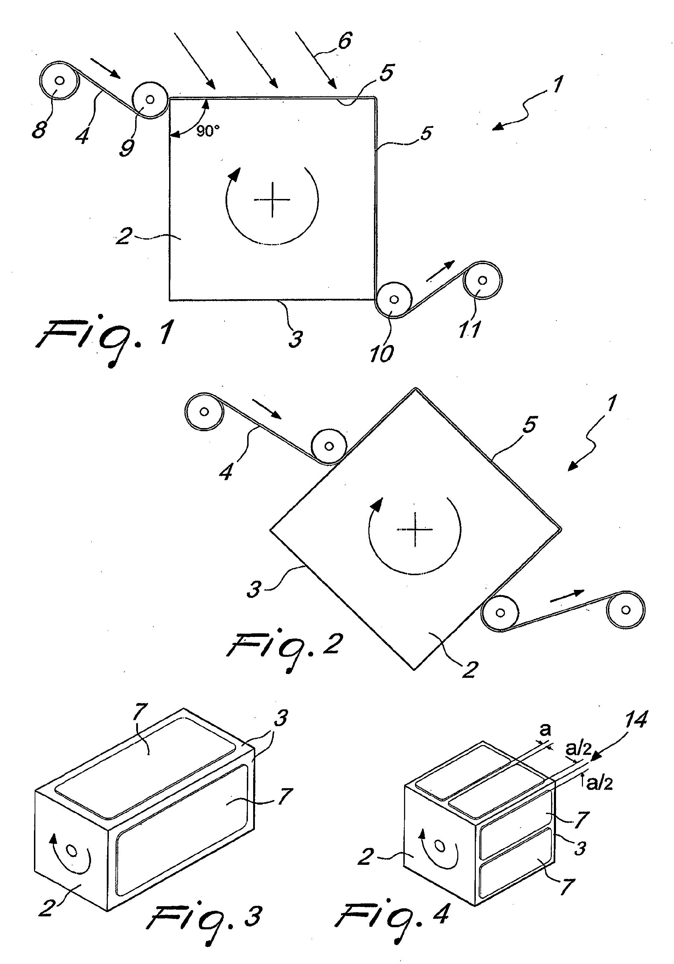

In **Fig. 1** ist eine erfindungsgemäße Vorrichtung 1 in erster Ausführungsvariante dargestellt, die als Zentral-Element eine Polygon-Trommel, hier eine Quadrat-Trommel 2 besitzt. Die vier ebenen Außenflächen der Trommel 2 sind jeweils mit mindestens einem Master-Hologramm bestückt und werden im Weiteren als Master-Flächen bezeichnet. Über diese ebenen Master-Flächen 3 ist ein holographischer Film 4 so über zwei aufeinanderfolgende Flächen geführt, dass diese in bestimmter Trommel-Ausrichtung zwei der vier Flächen als "aktive" Master-Flächen einer vollflächigen Belichtung durch Laserstrahlen 6 zugänglich sind. Dabei wird der holographische Film, der in bekannter Weise aus einer Trägerfolie, einer Photopolymerschicht und einer Schutzfolie besteht, von einer Abwickelrolle 8 zu einer Auflaminier-Rolle 9 geführt und so auf die Tommel aufgebracht, dass die nach vorhergehendem Abziehen der Schutzfolie (nicht dargestellt) gut kontaktierend haftende Photopolymerschicht fest auf die Trommel und insbesondere auf den darauf befindlichen Mastern in sicheren Kontakt gebracht sind und nachfolgend zusammen mit der Trommel die entsprechende Rotationsbewegung durchführt, vorliegend im Uhrzeigersinn. Der belichtete Film, mit den einkopierten Hologrammen wird dann über eine hier annähernd diagonal zur Auflaminier-Rolle 9 angeordnete Entlaminier-Rolle 10 von der Trommel abgezogen und auf eine Aufwickelrolle 11 aufgebracht, wobei jedoch vor dem Aufwickeln auf die Photopolymerschicht eine Schutzfolie aufgebracht wird (nicht dargestellt).

Hier wird präzisierend darauf hingewiesen, dass die "... Rolle" 8, 9, 10,11 jeweils die Breite bzw. Länge der Trommel besitzt, also als "... Walze" zu verstehen ist und im Weiteren auch meist so benannt wird.

Aus dieser Abbildung ist auch zu erkennen, dass eine vollflächige Laser-Belichtung 6 nur auf einer der beiden aktiven Master-Flächen 5 stattfinden kann oder gleichzeitig auf beiden aktiven Master-Flächen 5.

Aus Fig. 1 ist auch zu erkennen, dass in der dargestellten Position der Trommel 2 horizontal und vertikal weisende Master-Flächen vorhanden sind. Die Trommel wird dabei während der Belichtung kontinuierlich rotieren, wobei nur eine der beiden aktiven Master-Flächen 5, z. B. die obere horizontale Fläche oder beide Flächen gleichzeitig mit identischen Kopierstrahlen belichtbar ist. Es kann aber auch so vorgegangen werden, dass auf der oberen horizontalen Fläche 5 ein Hologramm in den Film 4 einkopiert wird, während gleichzeitig auf der zweiten vertikalen Fläche 5 ein anderes, zweites Hologramm einkopiert wird. Es besteht somit die Möglichkeit, ein aus zwei unterschiedlichen Hologrammen bestehendes Hologramm-Mix in den Film einzukopieren.

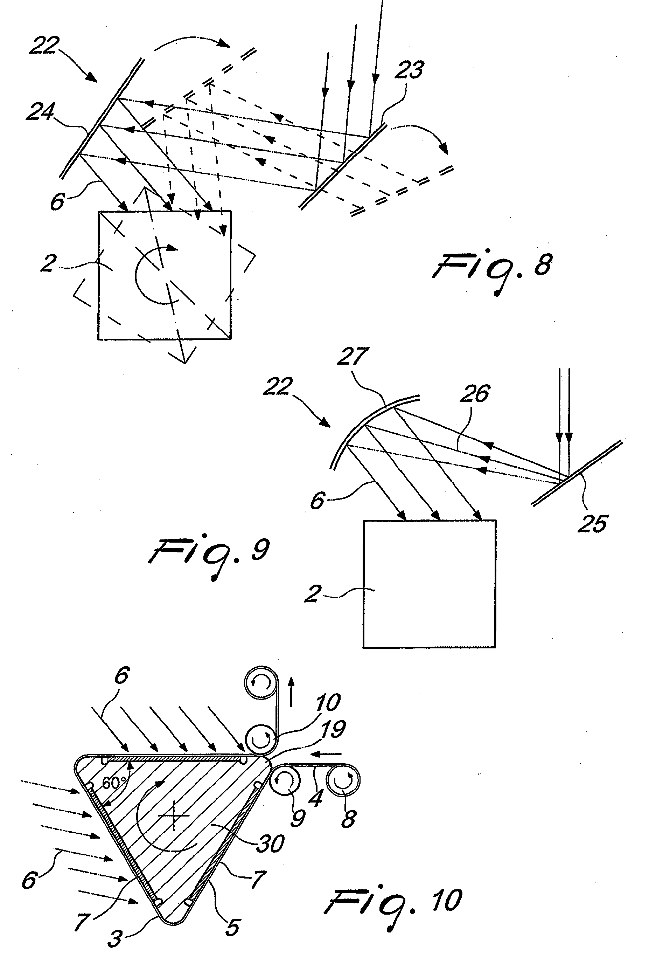

In **Fig. 2** ist erneut die Kopier-Vorrichtung aus Fig. 1 dargestellt, jedoch mit der Quadrat-Trommel 2 in einer um 90° verschwenkten Position. Aus dieser Darstellung ist zu erkennen, dass lediglich eine der Master-Flächen 3 als voll aktive Master-Fläche 5 anzusehen ist, während die beiden anliegenden Master-Flächen 3 nur teilweise mit dem Film 4 bedeckt sind. Somit bestünde hier lediglich für die eine aktive Master-Fläche 5 die Möglichkeit der Weiterführung der vollflächigen Laser-Belichtung, erfindungsgemäß mit kontinuierlich drehender Tommel und mitschwenkender Belichtungseinrichtung, wie nachfolgend im Zusammenhang mit Fig. 8 näher erläutert wird.

**Fig. 3** veranschaulicht, wie auf den ebenen Master-Flächen der Quadrat-Trommel 2 jeweils ein Master-Hologramm 7 aufgebracht ist, wodurch vier Master-Flächen 3 vorhanden sind.

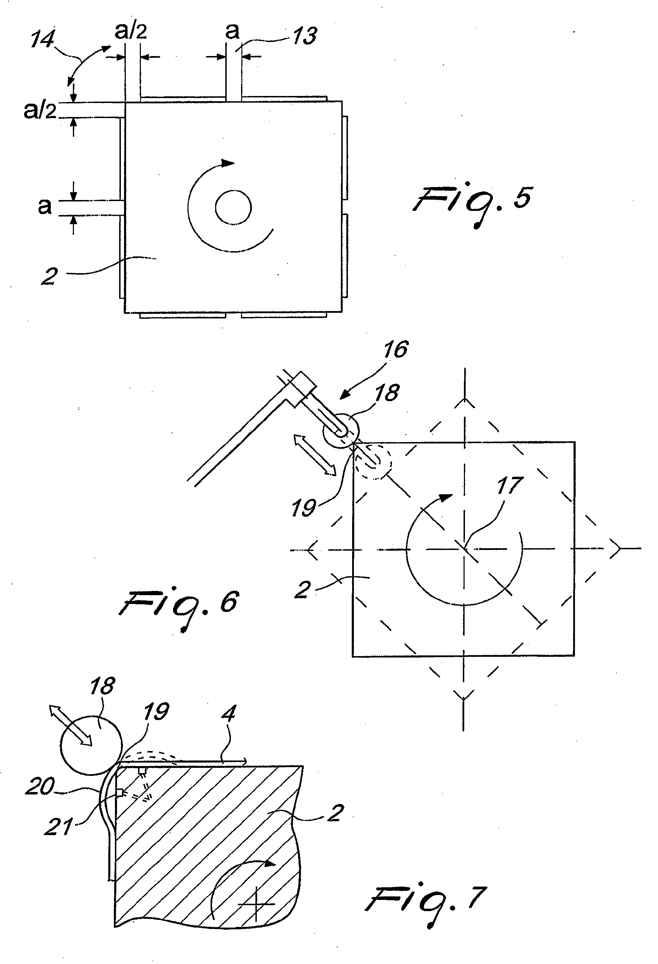

In **Fig. 4** **und** **Fig. 5** ist wiederum dargestellt, wie auf einer Quadrat-Trommel 2 in weiterer Ausführung auf einer jeden Master-Fläche 3 zwei Master-Hologramme 7 in Umfangsrichtung aufeinander folgend angeordnet sind. Dabei sind dieser Master 7 in Umfangsrichtung gesehen jeweils genau zueinander beabstandet, also mit Abständen "a", wobei die Innenabstände 13, also die Abstände zwischen den Mastern einer Fläche identisch sind mit den Außenabständen 14, also den Abständen zwischen den benachbart übers Eck aufeinander folgenden Master-Hologrammen 7 benachbarter Master-Flächen 3. Diese identische Beabstandung ist sehr wichtig für das genaue Kopieren der Hologramme, aber auch für die weitere Ver- bzw. Bearbeitung des belichteten Films durch Aushärten, Aufbringen auf diverse Trägerelemente und Zuschneiden.

**Fig. 6** zeigt, wie eine Anpresseinrichtung 16 einer Trommel 2 zugeordnet ist. Diese besitzt eine radial zur Drehachse 17 der Trommel verschiebliche Anpressrolle 18, die stets in engem Kontakt mit der Oberfläche der Trommel steht und den notwendigen Anpressdruck zum ordnungsgemäßen Kontakt des Films mit der Trommeloberfläche und der darauf befindlichen Master-Hologramme 7 erbringt. In der hier dargestellten Position befindet sich die Trommel 2 in linearer Diagonalausrichtung zur Anpressrolle 18, also die Rolle befindet sich genau am Polygon-Eck 19. Bei Verschwenken der Trommel um 45°, was in unterbrochener Linie eingezeichnet ist, befindet sich die Anpressrolle in ihrer tiefsten Position, mittig auf der Trommelfläche. Hieraus ist zu erkennen, dass die Anpressrolle stets entsprechend mitläuft und den Film fortlaufend in engem Kontakt mit der aktiven Master-Fläche hält oder in einen solchen Kontakt bringt. Die Anpressrolle kann dabei gleichzeitig die Auflaminierrolle 9 sein (siehe Fig. 1) oder kann zusätzlich auch noch an einem Eck zwischen zwei aktiven Master-Flächen vorgesehen sein, um einem bauchig abstehenden Ablösen an dem Eck entgegen zu wirken, was insbesondere bei kleinen Polygon-Eckwinkeln von 90° einer Quadrat-Trommel oder gar 60° einer Dreieck-Trommel, je nach Steifigkeit des Films und/oder geringer Klebefähigkeit der Photopolymerschicht, verstärkt auftreten kann.

Ein solcher Fall einer Aufbauchung des Films ist in **Fig. 7** dargestellt. Es ist hier zu erkennen, wie der um ein 90°-Eck 19 geführter Film 4 sich relativ stark federelastisch zu einer Bauchung 20 abspreizt, was jedoch durch die Anpressrolle 18 ausgebügelt wird. Im Polygoneck 19 ist hier auch noch eine Ansaugeinrichtung 21 vorgesehen, die jedoch nur schematisch in Form von Kanälen dargestellt ist. Somit ist durch rollenden Druck von außen durch die Anpressrolle 18 und durch die Vakuum-Ansaugkraft von innen durch die Ansaugeinrichtung 21 ein konstanter korrekter Kontakt zwischen Film und Trommel auch über kleine Eckwinkel zu erreichen.

In **Fig. 8** ist dargestellt, wie die zugeordnete Belichtungseinrichtung 22 jeweils abschnittsweise mit der kontinuierlich rotierenden Trommel 2 synchron so mitschwenkt, dass die vollflächige Laser-Belichtung 6 in ausreichend langer Belichtungszeit vorhanden ist bzw. auf Master und Film einwirkt, z. B. mindestens 0,1 sec für Polymerfilme und bei nichtdiffusionsabhängigen Filmen im Nanosekundenbereich. Dabei weist die Belichtungseinrichtung 22 u. a. zwei Spiegel auf, hier zwei ebene Spiegel 23 und 24, die einfallende parallele Laserstrahlen als solche so weiterleiten, dass vollflächig die Master-Fläche belichtende kohärente Laser-Stahlen 6 in vorbestimmtem Rekonstruktionswinkel auf den Master und den darauf befindlichen Film auftreffen. In unterbrochener Linie ist zudem dargestellt, wie wegen der kontinuierlich rotierenden Trommel 2 die Belichtungseinrichtung ebenfalls eine entsprechende Rotationsbewegung ausübt, so dass zumindest für die notwendige Belichtungszeit die Laserstrahlen 6 unter gleichen Bedingungen, insbesondere gleichem Einfallwinkel und gleicher Position auf die zu belichtende Fläche auftreffen.

**Fig. 9** zeigt, wie die Belichtungseinrichtung 22 mit einer anderen Spiegel-Konfiguration ausgerüstet sein kann. So ist der erste Spiegel 25 hier so geformt, dass die eintreffenden Strahlen als divergentes Strahlenbündel 26 auf einen Hohlspiegel 27 geleitet sind, der so geformt und ausgerichtet ist, dass parallele kohärente Strahlung auf den (nicht dargestellten) Film 4 und das darunter befindlicher Masterhologramm 7 vollflächig auftreffen. Auch hier folgt die gesamte Belichtungseinrichtung 22 abschnittsweise synchron der Drehbewegung der Trommel 2, um dann wieder in die Ausgangsposition zurückgeführt zu werden.

**Fig. 10** zeigt eine erfindungsgemäße Vorrichtung, die eine Dreieck-Trommel 30 besitzt. Sie hat somit drei Master-Flächen 3, auf denen jeweils ein Master-Hologramm 7 aufgespannt bzw. befestigt ist. Der Film 4 wird auch hier von einer Abwickelrolle 8 über eine Auflaminierrolle 9 auf die Trommel aufgebracht und zwar nahe einem der Trommelecken 19. Der auflaminierte Film 4 befindet sich dabei auf allen drei Trommelflächen kontaktierend geführt und wird erneut nahe dem Polygoneck 19 über eine Entlaminierrolle 10 von der Trommel abgezogen und auf die Aufwickelrolle 11 aufgebracht. Da die beiden Rollen 9 und 10 sehr nahe dem Eck 19 zugeordnet sind, besteht die Möglichkeit, nicht nur die diagonal zum Eck 19 gegenüber liegende Master-Fläche mit Laserstrahlen 6 vollflächig zu belichten, sondern auch die beiden weiteren, das Eck 19 bildenden Flächen. Hierdurch können somit jeweils ein oder gleichzeitig zwei oder drei Hologramme kopiert werden.

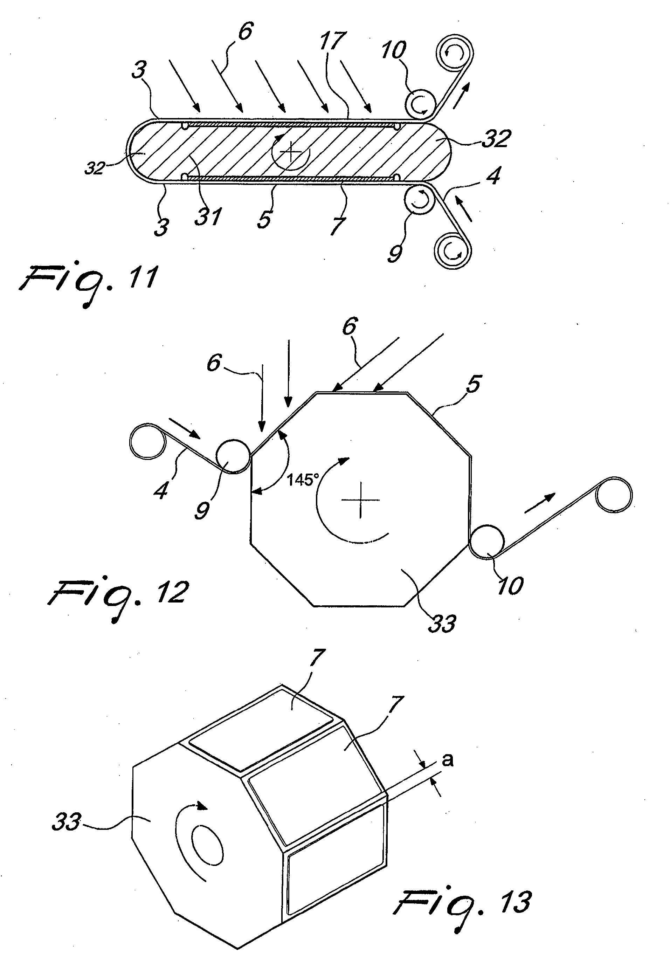

In **Fig. 11** ist eine erfindungsgemäße Vorrichtung dargestellt, die eine flache Rechteck-Trommel 31 besitzt. Diese hat zwei ebene Master-Flächen 3, die parallel zueinander ausgerichtet und mit je einem Masterhologramm 7 bestückt sind, während die Schmalseiten als halbkreisförmige Abrundungen 32 ausgeführt sind. Die Zu- und Ableitung des Films 4 durch die Rollen 9 und 10 erfolgt hier ebenfalls ganz außen an einer der abgerundeten Flach-Seiten, so dass zwei aktive Master-Flächen vorhanden sind. Durch die einen sehr großen Radius aufweisende Abrundung 32 kann der darüber geführte Film 4 auch in sehr gutem Kontakt mit allen aktiven Flächen der Trommel 32 gehalten werden. Es ist zu erkennen, dass auch hier stets nur eine Fläche laserbelichtet werden kann oder beide Flächen zugleich.

**Fig. 12** zeigt eine erfindungsgemäße Vorrichtung mit einer Achteck-Trommel 33, bei der über eine Auflaminierrolle 9 und eine Entlaminierrolle 10 der holographische Film 4 in engem Kontakt auf die Trommel so aufgebracht und abgeführt wird, dass der Film mit vier Polygon-Flächen gleichzeitig in Kontakt steht und somit aufeinanderfolgend vier aktive Master-Flächen vorhanden sind. Damit besteht die Möglichkeit, dass alle vier Flächen einzeln oder gleichzeitig oder z. B. je zwei genommen Laser-belichtet werden. Dabei ist auch möglich, dass auf der Trommel 33 nicht acht identische Master-Hologramme aufgebracht sind, sondern z. B. zwei oder mehr unterschiedliche Master, so dass auf dem Film mehrere unterschiedliche Hologramme gleichzeitig einkopierbar sind. Hierdurch kann die hochproduktive Vorrichtung sehr wirtschaftlich ausgelastet werden. Selbstverständlich bestände auch hier die (unproduktivere, nicht beanspruchte) Möglichkeit der schrittweisen Rotation um einen oder gleichzeitig um zwei, drei oder alle acht Teilungswinkel mit jeweils anschließender vollflächiger Belichtung.

**Fig. 13** zeigt die Trommel 33 der Vorrichtung nach Fig. 12 und wie deren ebenen Polygon-Flächen jeweils mit einem Maserhologramm 7 ausgerüstet sind. Auch hier sind die Masterhologramme 7 auf den jeweiligen Master-Flächen so angeordnet, dass der Abstand "a" zwischen den jeweils benachbarten Masterhologrammen identisch ist.

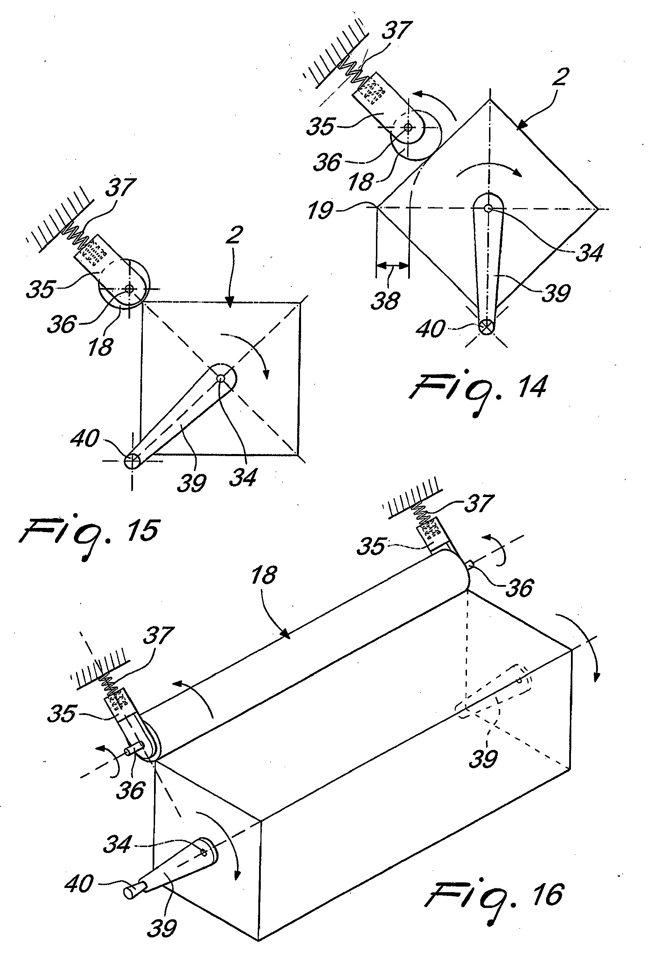

Schließlich zeigen **Fig. 14 bis 16** eine Anpresseinrichtung 16 in weiterer Ausführung und Arbeitsweise. Deren Anpresswalze 18 ist nämlich an beiden Enden exzentrisch gelagert in je einem Haltearm 35, wobei je ein Exzenterbolzen 36 koaxial zur exzentrischen Rotationsachse der Anpresswalze 18 stirnseitig von den Haltearmen abragt. Die Halearme 35 sind dabei von einer Druckfeder 37 in Richtung auf die Rotationsachse der Trommel 2 (radial) gedrückt gehalten.

**Fig. 14** veranschaulicht, wie die Anpreßwalze 18 in seitenmittiger Position zur Quadrat-Trommel 2, also in einer zur Rotationsachse 34 am nächsten liegenden Position steht. Dabei befindet sich die Anpreßwalze 18 in ihrer exzentrisch vorderen oder vorgerückten Position. Durch gestrichelt eingezeichneten Kreisbogen ist die Wegdifferenz oder der Hub 38 im Verhältnis zur größten Entfernung des Polygoneckes 19 zur zentralen Rotationsachse 34 der Trommel angedeutet.

Zudem ist zu erkennen, wie stirnseitig an der Trommel (je) ein Hebel 39 befestigt ist, an dessen äußerem Ende eine Abhebrolle 40 angeordnet ist. Diese ist wiederum so vorgesehen, dass sie bei einer jeden Umdrehung der Trommel mit dem entsprechenden Exzenterbolzen 36 zusammenwirkt und dabei die Anpresswalze 18 abhebt, wodurch die Umlauftoleranz ausgeglichen wird.

**Fig. 15** zeigt eine um 45° verdrehte Position der Trommel 2, in der die Anpreßwalze 18 auf dem Polygon-Eck 19 diagonal weisend ansteht. Dabei befindet sich die Anpresswalze 18 in ihrer exzentrisch hochgeschobenen und somit im Verhältnis zur Rotationsachse 34 der Trommel höchsten Position. Aus dem Vergleich der beiden Fig. 14 und 15 ist zu erkennen, dass die ausgleichende radiale Bewegung im Wesentlichen nur durch die exzentrisch ausgelegte Anpresswalze 18 durchgeführt wird, während die Haltearme 35 keine Hubbewegung auszuführen haben. Daher ist der Anpressdruck der Federn auf die Haltearme und damit auf die Walze 18 und über diese auf den holographischen Film, stets konstant.

**Fig. 16** veranschaulicht nun eine Trommel-Position wie in Fig. 15, wobei hier beide endseitigen Lagerungen bzw. federnden Haltearmen 35 der Anpresswalze 18 und beide stirnseitigen Hebel 39 mit ihren Abhebrollen 40 und deren Wirkung zu erkennen sind.

**Bezugszeichenliste**

| | | | |
|---|---|---|---|
| **1.** | Vorrichtung | **21.** | Ansaugeinrichtung |
| **2.** | Quadrat-Trommel | **22.** | Belichtungseinrichtung |
| **3.** | Master-Fläche | **23.** | Spiegel |
| **4.** | holographischer Film | **24.** | Spiegel |
| **5.** | aktive Master-Fläche | **25.** | Spiegel |
| **6.** | Laser-Strahl (-Belichtung) | **26.** | divergente Strahlung |
| **7.** | Master (-Hologramm) | **27.** | Hohlspiegel |
| **8.** | Abwickelrolle (-walze) | **28.** | --- |
| **9.** | Auflaminierrolle (-walze) | **29.** | --- |
| **10.** | Entlaminierrolle (-walze) | **30.** | Dreieck-Trommel |
| **11.** | Abwickelrolle (-walze) | **31.** | Rechteck-Trommel |
| **12**. | ---- | **32.** | Abrundung |
| **13.** | Innenabstand | **33.** | Achteck-Trommel |
| **14.** | Außenabstand | **34.** | Rotationsachse (-zentrum) |
| **15.** | ---- | **35.** | Haltearm |
| **16.** | Anpresseinrichtung | **36.** | Exzenterbolzen |
| **17.** | Drehachse | **37.** | Druckfeder |
| **18.** | Anpressrolle (-walze) | **38.** | Hub |
| **19.** | Polygoneck | **39.** | Hebel |
| **20.** | Bauchung | **40.** | Abhebrolle |
| | | | |
| "a" | Umfangsabstand | | |

## Patentansprüche

1. Verfahren zum Herstellen von Kontaktkopien von Reflexions-Volumenhologrammen auf einem holographischen Film (4), bei dem
- der Film (4) über eine rotierende Trommel mit einem polygonalen Querschnitt geführt wird, wobei mindestens zwei ebene Master-Flächen (3) an der Trommel vorhanden sind, auf denen jeweils ein Master-Hologramm (7) befestigt ist und zusammen mit dem Master-Hologramm durch oder in einen Belichtungsbereich bewegt wird, in welchem der Film und das Master-Hologramm mindestens eine Laser-Belichtung (6) unterworfen werden, um das Master-Hologramm in der photoempfindlichen Schicht des Films zu reproduzieren,
- eine Anpreßeinrichtung zum engen Anliegen des Films an der Trommel vorhanden ist,
**dadurch gekennzeichnet,**
- **dass** die Trommel gleichmäßig rotiert, wobei sich jeweils mindestens eine Polygon-Fläche oder Master-Fläche (3, 5) mit darauf befindlichem Master-Hologramm (7) im Belichtungsbereich befindet,
- **dass** die mindestens eine Laser-Belichtung (6) eine kohärente parallele, ganz-/vollflächige Strahlung ist, die jeweils über die gesamte Master-Fläche (3) oder die Fläche der jeweiligen Master-Hologramme (7) einer Master-Fläche oder mehrerer Master-Flächen gleichzeitig erfolgt,
- wobei die mindestens eine Laser-Belichtung (6) jeweils abschnittsweise der Rotationsbewegung der Trommel mit gleicher Geschwindigkeit so folgt, dass die vollflächige Laser-Belichtung (6) in ausreichend langer Belichtungszeit vorhanden ist und auf Master und Film unter gleichbleibenden Einfallswinkel einwirkt, um danach wieder in ihre Anfangs- oder Ausgangsposition zurückgesetzt zu werden und gemeinsam mit der nächsten Master-Fläche wieder die gleiche Winkel-Verschwenkung und Belichtung durchzuführen.

2. Verfahren nach Anspruch 1, **dadurch gekennzeichnet,**
**dass** eine Master-Fläche (3) oder zwei oder mehr Master-Flächen gleichzeitig flächig laserbelichtet werden, -z. B. bei einem Achteck-Polygon (33) mit acht Mastern, gleichzeitig vier Master belichtet werden.

3. Verfahren nach Anspruch 2, **dadurch gekennzeichnet,**
**dass** auf einer aktiven Master-Fläche (5) ein Hologramm in den Film einkopiert wird, während gleichzeitig auf einer zweiten aktiven Master-Fläche (5') ein anderes, zweites Hologramm einkopiert wird, wobei dadurch ein aus zwei unterschiedlichen Hologrammen bestehendes Hologramm-Mix einkopierbar ist.

4. Verfahren nach Anspruch 1, **dadurch gekennzeichnet,**
**dass** die Anpresseinrichtung (16) mit von außen wirksamen mechanischen, elektrischen, magnetischen oder eine Kombination dieser betätigten Anpressrollen oder - walzen (18) und/oder ein von innen wirksames Vakuum (Unterdruck) einer Ansaugeinrichtung (21) ein enges Anliegen des Films (4) an den Polygonecken (19) erwirkt wird,
wobei die Anpreßwalzen (18) exzentrisch lagerbar sind, so dass die radialen Hübe (38) ausgeglichen werden und ein konstanter Anpressdruck vorhanden ist, wobei die Anpresswalzen (18) nach einer jeden Umdrehung der Trommel (2) abgehoben (39, 40) werden, zum Ausgleich der Umlauftoleranzen.

5. Verfahren nach Anspruch 1, **dadurch gekennzeichnet,**
**dass** die mindestens eine Laser-Belichtung durch eine Belichtungseinheit (22) erfolgt, die z. B. einen Hohlspiegel (27) besitzt und in gleicher Winkelgeschwindigkeit wie die Trommel mit verschwenkt wird.

6. Verfahren nach Anspruch 5, **dadurch gekennzeichnet,**
**dass** bei Vorhandensein eines Hohlspiegels (27) in der Belichtungseinheit (22) die Laserstrahlen über einen ersten Spiegel (25) als divergente Strahlung (26) auf den Hohlspiegel (27) und von diesem als parallele Strahlung (6) auf die aktive Master-Fläche im entsprechenden Kopier-Winkel gelenkt wird oder dass die Belichtungseinheit (22) zwei Umlenkspiegel (23, 24) besitzt, welche die parallele Strahlung entsprechend weiterleiten.

7. Vorrichtung zum Durchführen des Verfahrens nach den Ansprüchen 1 bis 6, mit
- einer Trommel (2, 30, 31, 33) mit einem Polygon-Querschnitt mit mindestens zwei ebenen (Polygon-) Master-Flächen (3) zum Mitführen eines holographischen Films (4) und zum Kontaktieren des Films mit einem auf der Master-Fläche (3, 5) befestigten Master-Reflexionshologramm (7),
- einer Belichtungseinheit (22), die Laserstrahlen (6) vollflächig auf die Master-Fläche lenkt,
- einem Antriebsmechanismus zum simultanen gemeinsamen Bewegen des Master-Hologramms und des Films durch einen Laser-Belichtungsbereich, in welchem der Film und das Master-Hologramm Laser-belichtet werden, um das Master-Hologramm im holographischen Film zu reproduzieren,
- und einer Anpreßeinrichtung zum engen Anliegen des Films an der Trommel vorhanden ist,
**dadurch gekennzeichnet,**
- **dass** mindestens einer der aktiven Master-Flächen (5) mit darübergeführtem Film (4) eine Laser-Belichtungseinheit (22) zugeordnet ist, die eine volle Belichtung der jeweiligen Master-Fläche (5) mit kohärenten Laserstrahlen (6) ermöglicht.
- **dass** der Antriebsmechanismus der Trommel zur konstanten Rotation ausgelegt ist, wobei die mindestens eine Belichtungseinrichtung (22) jeweils abschnittsweise der Rotationsbewegung der Trommel mit gleicher Geschwindigkeit folgt und dabei die zugehörige Master-Fläche (5) ganzflächig, unter gleichbleibenden Einfallswinkel, voll belichtet, um danach wieder in ihre Anfangs- oder Ausgangsposition zurückgesetzt zu werden und gemeinsam mit der nächsten Master-Fläche wieder die gleiche Winkel-Verschwenkung und Belichtung durchzuführen.

8. Vorrichtung nach Anspruch 7, **dadurch gekennzeichnet,**
**dass** die Polygon-Trommel eine Rechteck-Trommel (31) mit im Querschnitt flachem Rechteck mit zwei Master-Flächen (5), eine Dreieck-Trommel (30) als Dreieck mit drei Master-Flächen, eine Quadrat-Trommel (2) mit einem Quadrat-Querschnitt mit vier Master-Flächen oder eine Fünfeck-, eine Sechseck-, Siebeneck-, Achteck- (33) oder n-Eck-Trommel mit entsprechender Anzahl von Master-Flächen (3) ist, wobei der Film über mindestens zwei bis n-1 Master-Flächen geführt ist.

9. Vorrichtung nach Anspruch 7, **dadurch gekennzeichnet,**
**dass** auf den Master-Flächen (3) in Umfangsrichtung jeweils zwei oder mehr Master-Hologramme (7) befestigt sind und dass bei mehreren Master-Hologrammen (7) per Master-Fläche (3) die Umfangsabstände (13) zwischen den Master-Hologrammen einer Fläche und die Abstände (14) zwischen den Masern benachbarter Master-Flächen über die Polygonecken identisch sind.

10. Vorrichtung nach Anspruch 7, **dadurch gekennzeichnet,**
**dass** eine Anpresseinrichtung (16) mit einer von außen wirksamen mechanischen, pneumatischen, hydraulischen elektrischen, magnetischen oder einer Kombination dieser Möglichkeiten betätigten Anpresswalzen (18) und/oder eine Ansaugeinrichtung (21) mit einem von innen wirksamem Vakuum (Unterdruck) vorgesehen ist.

11. Vorrichtung nach Anspruch 10, **dadurch gekennzeichnet,**
**dass** die z. B. über endseitige Haltearme (35) mit Druckfedern (37) angedrückt gehaltene Anpresswalze (18) exzentrisch gelagert ist, so dass die radialen Hübe der Polygontrommel ausgeglichen werden und ein konstanter Anpressdruck realisiert wird, und dass stirnseitig an der Trommel mit dieser mitlaufend je ein Hebel (39) mit endseitiger Abhebrolle (40) vorgesehen ist, die zum Zusammenwirken mit den seitlichen Exzenterbolzen (36) der Anpresswalzen (18) so ausgelegt sind, dass bei einer jeden Trommel-Umdrehung die Anpreßwalze (18) angehoben und dadurch die Umfangtoleranz ausgeglichen wird.

12. Vorrichtung nach Anspruch 7, **dadurch gekennzeichnet,**
**dass** mindestens ein Umlenkspiegel (23, 24, 25, 27) der Belichtungseinrichtung (22) verschwenkbar ist, so dass bei kontinuierlich rotierender Trommel eine entsprechende Schwenkbewegung der Laser-Belichtung (6) mit identischer Winkelgeschwindigkeit ausführbar ist,
wobei die Belichtungseinrichtung (22) mindestens einen letzten Spiegel (24, 27) umfasst, der parallele Laser Strahlen (6) zur Masterbelichtung abgibt, und wobei bei Vorhandensein von zwei Spiegeln, der erste Spiegel (25) divergierende Strahlung (26) und der zweite, ein Hohlspiegel (27), diese Strahlung in parallele Strahlung (6) umwandelt.

13. Vorrichtung nach Anspruch 7, **dadurch gekennzeichnet,**
**dass** die Master-Trommel als magnetische oder mit magnetischen Elementen ausgerüstete Trommel ausgebildet ist,

## Claims

1. Method for producing contact prints of volume reflection holograms on a holographic film (4), wherein
- the film (4) is guided over a rotating drum with a polygonal cross-section, at least two level master surfaces (3) being present on the drum, to each of which a master hologram (7) is fixed, which is moved together with the master hologram through or into an exposure area, in which the film and the master hologram are subjected to at least one laser exposure (6) so as to reproduce the master hologram in the photo-sensitive layer of the film,
- a contact pressure device is present for close adherence of the film to the drum,
**characterized in that**
- the drum rotates constantly, wherein at least one polygonal face or master surface (3, 5) at a time with the master hologram (7) on it is located in the exposure area,
- the laser exposure (6) is at least one coherent parallel radiation covering the entire/full surface, i. e. the entire master surface (3) or the surface of the respective master holograms (7) of a master surface or several master surfaces at the same time,
- wherein the at least one laser exposure sequentially follows the rotational movement of the drum with equal speed, such that the laser exposure (6) covering the entire surface is present for an exposure time which is sufficiently long and, at an incident angle which remains the same, affects master and film, so as to be subsequently reset into its initial or starting position and then to perform the same angular sweep and exposure together with the next master surface.

2. Method according to Claim 1, **characterized in that**
one master surface (3) or two or more master surfaces are exposed to laser exposure at the same time with their entire area, e. g. in case of an octagonal polygon (33) with eight masters, four masters are exposed simultaneously.

3. Method according to Claim 2, **characterized in that**
on an active master surface (5), a hologram is copied into the film, while at the same time a different, second hologram is copied into a second active master surface(5'), which makes it possible to copy a hologram mix consisting of two different holograms.

4. Method according to Claim 1, **characterized in that**
the contact pressure device (16) is implemented with pressure rollers (18) operating from the outside mechanically, electrically, magnetically or with a combination thereof and/or with an internally effective vacuum of a suction device (21) effecting a close adherence of the film (4) to the polygon corners (19),
where the pressure rollers (18) are arrangeable on eccentrical bearings so that the radial strokes (38) are compensated and a constant contact pressure is present, wherein the pressure rollers (18) are lifted (39, 40) after each rotation of the drum (2) so as to compensate for the rotation tolerances.

5. Method according to Claim 1, **characterized in that** the laser exposure takes place by means of an exposure unit (22) which possesses at least one e. g. concave mirror (27), and is swiveled with the same angular velocity as the drum.

6. Method according to Claim 5, **characterized in that**
if a concave mirror (27) is present in the exposure unit (22), the laser beams are directed as divergent radiation (26) via a first mirror (25) on the concave mirror (27) and from the latter, as parallel radiation (6) at the respective copying angle, on the active master surface, or **in that** the exposure unit (22) has two reflecting mirrors (23, 24) which forward the parallel radiation accordingly.

7. Device for performing the method according to Claims 1 through 6, having
- a drum (2, 30, 31, 33) with a polygonal cross-section, having at least two plane (polygonal) master surfaces (3) for entrainment of a holographic film (4) and for making the film contact a master reflection hologram (7) fastened on the master surface (3, 5),
- an exposure unit (22) which guides laser beams (6) onto the entire master surface,
- a drive mechanism for simultaneously moving the master hologram and the film together through a laser exposure area in which the film and the master hologram laser are exposed in order to reproduce the master hologram in the holographic film,
- and a contact pressure device for close adherence of the film to the drum,
**characterized in that**
- at least one of the active master surfaces (5) with the film (4) guided over it is assigned to a laser exposure unit (22) which allows complete exposure of the respective master surface (5) to coherent laser beams (6),
- the drive mechanism of the drum is adapted for constant rotation, wherein the at least one exposure unit (22) sequentially follows the rotational movement of the drum with equal speed and at the same time completely exposing the entire area of the corresponding master surface (5) with the incident angle remaining equal, so as to be subsequently reset into its initial or starting position and to then to perform the same angular sweep and exposure together with the next master surface.

8. Device according to Claim 7, **characterized in that** the polygonal drum is a rectangular drum (31) with a rectangle flat in cross-section, having two master surfaces (5), a triangular drum (30) as a triangle with three master surfaces, a square drum (2) with a square cross-section having four master surfaces or a pentangular, hexangular, heptangular, octangular (33) or n-angular drum with a corresponding number of master surfaces (3), where the film is guided over at least two to n-1 master surfaces.

9. Device according to Claim 7, **characterized in that**
on the master surfaces (3), two or more master holograms (7) each are fastened in the circumferential direction, and **in that** with several master holograms (7) per master surface (3), the circumferential spacings (13) between the master holograms of one surface and the spacings (14) between the masters of adjacent master surfaces over the polygon angles are identical.

10. Device according to Claim 7, **characterized in that**
a contact pressure device (16) is provided with pressure rollers (18) activated from outside mechanically, pneumatically, hydraulically, electrically, magnetically or by a combination of these possibilities and/or a suction device (21) having a vacuum effective from the inside is provided.

11. Device according to Claim 10, **characterized in that**
the pressure roller (18) being pressed and held on e. g. by means of pressure springs (37) via support arms (35) at their ends, is arranged on eccentrical bearings, so that the radial strokes of the polygonal drum are compensated and a constant contact pressure is achieved, and **in that** on the end faces of the drum, revolving with it, one lever (39) each with a lifting roller (40) at the end is provided which, for cooperation with the lateral eccentric bolts (36) of the pressure rollers (18), which are adapted such that with each rotation of the drum, the pressure roller (18) is lifted and thus the circumferential tolerance is compensated.

12. Device according to Claim 7, **characterized in that**
at least one reflecting mirror (23, 24, 25, 27) of the exposure device can be swiveled so that with a continuously rotating drum, a corresponding swivel movement of the laser exposure (6) with identical angular velocity can be performed,
wherein the exposure device (22) comprises at least one last mirror (24, 27) which emits parallel laser beams (6) for master exposure, and in the case of two mirrors, the first mirror (25) transmits divergent radiation (26) and the second concave mirror (27) transforms this radiation into parallel radiation (6).

13. Device according to Claim 7, **characterized in that** the master drum is embodied as a magnetic drum or a drum equipped with magnetic elements.

## Revendications

1. Procédé pour la fabrication de copies par contact d'hologrammes volumiques par réflexion sur un film holographique (4), dans lequel
- le film (4) est guidé par l'intermédiaire d'un tambour tournant avec une section transversale polygonale, dans lequel il y a au moins deux surfaces de maître (3) planes au niveau du tambour sur lesquelles respectivement un hologramme maître (7) est fixé et que l'on déplace, ensemble avec l'hologramme maître, à travers une zone d'irradiation ou dans celle-ci, dans laquelle zone le film et l'hologramme maître sont soumis à au moins une irradiation au laser (6) afin de reproduire l'hologramme maître dans la couche photosensible du film,
- un dispositif presseur étant présent pour que le film adhère uniformément au tambour,
**caractérisé**
- **en ce que** le tambour tourne régulièrement, dans lequel, respectivement au moins une surface polygonale ou surface de maître (3, 5) avec l'hologramme maître (7) se trouvant dessus, se trouve dans la zone d'irradiation,
- **en ce que** l'irradiation au laser (6), est au moins une irradiation cohérente parallèle sur la toute la surface/l'ensemble de la surface, laquelle a lieu respectivement sur l'ensemble de la surface de maître (3) ou la surface des hologrammes maître (7) respectifs d'une surface de maître ou de plusieurs surfaces de maître simultanément,
- dans lequel l'au moins une irradiation au laser (6) suit, au moins en partie, le mouvement de rotation du tambour à la même vitesse de telle sorte que l'irradiation au laser (6) sur toute la surface ait lieu avec un temps d'irradiation suffisamment long et agisse sur le maître et le film avec un angle d'incidence ne variant pas, pour ensuite de nouveau être ramenée en arrière dans sa position initiale ou de départ et de nouveau effectuer, ensemble avec la surface de maître suivante, le même pivotement angulaire et l'irradiation.

2. Procédé selon la revendication 1, **caractérisé en ce**
**qu'**une surface de maître (3), ou deux ou davantage de surfaces de maître, sont simultanément soumises, en nappe, à une irradiation au laser, dans le cas par exemple d'un polygone (33) à huit côtés avec huit maîtres, quatre maîtres étant irradiés simultanément.

3. Procédé selon la revendication 2, **caractérisé en ce**
**que**, sur une surface de maître (5) active, un hologramme est copié dans le film pendant que simultanément, sur une deuxième surface de maître (5') active, un autre, deuxième hologramme est copié, dans lequel, de ce fait, un mélange d'hologrammes se composant de deux hologrammes différents peut être copié.

4. Procédé selon la revendication 1, **caractérisé en ce**
**que** le dispositif presseur (16) avec des rouleaux ou cylindres presseurs (18) efficaces de l'extérieur, mécaniques, électriques, magnétiques ou actionnés selon une combinaison de ces possibilités et/ou en ce qu'un vide (dépression) efficace de l'intérieur d'un dispositif d'aspiration (21), font en sorte que le film (4) adhère uniformément aux angles du polygone (19),
dans lequel les cylindres presseurs (18) peuvent être montés de façon excentrique de manière à ce que les courses radiales (38) soient compensées et qu'une pression d'application constante existe, dans lequel les cylindres presseurs (18) sont soulevés (39, 40) après chaque tour du tambour (2) pour la compensation des tolérances rotatoires.

5. Procédé selon la revendication 1, **caractérisé en ce**
**que** l'irradiation au laser s'effectue grâce à un dispositif d'irradiation (22), lequel possède par exemple au moins un miroir concave (27) et que l'on fait pivoter avec, à la même vitesse angulaire que le tambour.

6. Procédé selon la revendication 5, **caractérisé en ce**
**que**, en cas d'existence d'un miroir concave (27) dans l'unité d'irradiation (22), les faisceaux laser sont guidés via un premier miroir (25) en tant que rayonnement divergeant (26) vers le miroir concave (27) et à partir de celui-ci, en tant que rayonnement parallèle (6), vers la surface de maître active selon l'angle de copiage correspondant, ou bien en ce que l'unité d'irradiation (22) possède deux miroirs de déviation (23, 24), lesquels retransmettent de manière correspondante le rayonnement parallèle.

7. Dispositif pour la mise en oeuvre du procédé selon les revendications 1 à 6, avec
- un tambour (2, 30, 31, 33) avec une section transversale polygonale avec au moins deux surfaces de maître (polygonales) (3) planes pour emmener un film holographique (4) et pour mettre le film en contact avec un hologramme par réflexion maître (7) fixé sur la surface de maître (3, 5),
- une unité d'irradiation (22), laquelle guide des faisceaux laser (6), sur toute la surface, sur la surface de maître,
- un mécanisme d'entraînement pour le déplacement conjoint simultané de l'hologramme maître et du film à travers une zone d'irradiation au laser dans laquelle le film et l'hologramme maître sont soumis à une irradiation au laser afin de reproduire l'hologramme maître dans le film holographique,
- et un dispositif presseur étant présent pour que le film adhère uniformément au tambour,
**caractérisé**
- **en ce qu'**au moins l'une des surfaces de maître (5) actives avec le film (4) guidé par-dessus est associée à une unité d'irradiation au laser (22) qui rend possible une irradiation complète de la surface de maître (5) respective avec des faisceaux laser (6) cohérents,
- **en ce que** le mécanisme d'entraînement du tambour est étudié pour une rotation constante, dans lequel l'au moins un dispositif d'irradiation (22) suit au moins en partie le mouvement de rotation du tambour à la même vitesse, et irradie ce faisant la surface de maître (5) associée sur l'ensemble de la surface avec un angle d'incidence ne variant pas, pour ensuite être de nouveau ramenée en arrière dans sa position initiale ou de départ et de nouveau effectuer, ensemble avec la surface de maître suivante, le même pivotement angulaire et l'irradiation.

8. Dispositif selon la revendication 7, **caractérisé en ce**
**que** le tambour polygonal est un tambour rectangulaire (31) avec un rectangle plat en section transversale avec deux surfaces de maître (5), un tambour triangulaire (30) en tant que triangle avec trois surfaces de maître, un tambour carré (2) avec une section transversale carrée avec quatre surfaces de maître ou un tambour à cinq angles, six angles, sept angles, huit angles (33) ou à n angles avec un nombre correspondant de surfaces de maître (3), dans lequel le film est guidé par l'intermédiaire d'au moins deux à n-1 surfaces de maître.

9. Dispositif selon la revendication 7, **caractérisé en ce**
**que** respectivement deux ou davantage d'hologrammes maîtres (7) sont fixés sur les surfaces de maître (3) en direction périphérique et en ce que, en cas de plusieurs hologrammes maîtres (7) par surface de maître (3), les distances de périphérie à périphérie (13) entre les hologrammes maîtres d'une surface et les distances (14) entre les maîtres de surfaces de maître voisines sont identiques sur les angles de polygone.

10. Dispositif selon la revendication 7, **caractérisé en ce**
**que** l'on prévoit un dispositif presseur (16) avec des cylindres presseurs (18) efficaces de l'extérieur, mécaniques, pneumatiques, hydrauliques électriques, magnétiques ou actionnés selon une combinaison de ces possibilités et/ou un dispositif d'aspiration (21) avec un vide (dépression) efficace de l'intérieur.

11. Dispositif selon la revendication 10, **caractérisé en ce**
**que** le cylindre presseur (18), par exemple tenu de manière pressée avec des ressorts de pression (37) via des bras de support (35) du côté d'extrémité, est monté de manière excentrique de sorte que les courses radiales du tambour polygonal soient compensées et qu'une pression appliquée constante soit réalisée et en ce que, du côté frontal sur le tambour, respectivement un levier (39) qui suit celui-ci est prévu avec un rouleau de soulèvement (40) du côté d'extrémité, lesquels sont étudiés pour la coopération avec les boulons d'excentrique (36) latéraux de cylindres presseurs (18) de manière à ce que, à chaque rotation de tambour, le cylindre presseur (18) est soulevé et que de ce fait, la tolérance périphérique est compensée.

12. Dispositif selon la revendication 7, **caractérisé en ce**
**qu'**au moins un miroir de déviation (23, 24, 25, 27) du dispositif d'irradiation (22) peut pivoter de manière à ce que, en cas d'un tambour tournant de façon constante, il est possible d'effectuer un mouvement de pivotement correspondant de l'irradiation au laser (6) avec une vitesse angulaire identique, dans lequel le dispositif d'irradiation (22) comprend au moins un dernier miroir (24, 27) qui émet des faisceaux laser (6) parallèles à l'irradiation du maître, et dans lequel, en cas d'existence de deux miroirs, le premier miroir (25) émet un rayonnement divergent (26) et le deuxième, un miroir concave (27), convertissant ce rayonnement en un rayonnement parallèle (6).

13. Dispositif selon la revendication 7, **caractérisé en ce**
**que** le tambour maître est réalisé en tant que tambour magnétique ou équipé d'éléments magnétiques.
